# EUROPÄISCHE PATENTSCHRIFT

(11) **EP 2 721 238 B1**
(45) Veröffentlichungstag und Bekanntmachung des Hinweises auf die Patenterteilung: **06.12.2017**
(21) Anmeldenummer: 12725828.3
(22) Anmeldetag: 06.06.2012
(51) Int. Cl.: E06B 3/663, E06B 3/667, H01L 31/02, H02S 40/34

(54) **ISOLIERVERGLASUNG MIT ELEKTRISCHEM ANSCHLUSSELEMENT**
INSULATING GLAZING WITH ELECTRICAL CONNECTION ELEMENT
VITRAGE ISOLANT POURVU D'UN ÉLÉMENT DE RACCORDEMENT ÉLECTRIQUE

(30) Priorität: 14.06.2011 EP 11169821
(43) Veröffentlichungstag der Anmeldung: 23.04.2014
(73) Patentinhaber: Saint-Gobain Glass France, 92400 Courbevoie (FR)
(72) Erfinder: MÜLLER, Marco, 52525 Waldfeucht (DE); PAFFEN, Karl-Heinz, 52134 Herzogenrath (DE); MESSERE, Rino, B-4577 Modave (BE); GILLISSEN, Manfred, 52134 Herzogenrath (DE); KLEINKE, Andreas, 58566 Kierspe (DE); GROTE, André, 42477 Radevormwald (DE); HOPPE, Markus, 58093 Hagen (DE)
(74) Vertreter: Gebauer, Dieter Edmund
(86) Internationale Anmeldenummer: PCT/EP2012/060758
(87) Internationale Veröffentlichungsnummer: WO 2012/171844

(56) Entgegenhaltungen:
- EP-A2- 1 529 922
- EP-A2- 1 655 442
- WO-A1-00/58580
- WO-A1-2011/046512
- DE-A1-102005 061 855

## Beschreibung

Die Erfindung umfasst eine Isolierverglasung mit elektrischem Anschlusselement, ein Verfahren zu deren Herstellung und deren Verwendung.

Isolierverglasungen sind aus modernen Gebäuden nicht mehr wegzudenken und machen einen zunehmend größeren Teil der nach außen gerichteten Verglasungen aus. Isolierverglasungen enthalten in der Regel mindestens zwei Scheiben aus Glas oder polymeren Materialen. Die Scheiben sind über einen vom Abstandshalter (Spacer) definierten Gas- oder Vakuumraum voneinander getrennt. Das Wärmedämmvermögen von Isolierglas ist deutlich höher als Einfachglas und kann in Dreifachverglasungen oder mit speziellen Beschichtungen noch weiter gesteigert und verbessert werden. Neben der wichtigen Eigenschaft der Wärmeisolierung spielen im Bereich der Gebäudeverglasung zunehmend auch optische und ästhetische Merkmale eine wichtige Rolle. Ein Beispiel hierfür sind beleuchtete Scheibenanordnungen. Diese beinhalten Scheiben und am Rand oder in den Scheiben angebrachte Leuchtmittel. Auf der Scheibenoberfläche aufgebrachte Reflexionselemente ermöglichen die Beleuchtung der Scheibenfläche. So lassen sich Innenräume aber auch Gebäudeaußenfassaden sehr gleichmäßig beleuchten. Beleuchtete Scheibenanordnungen finden sich in einer Vielzahl von Anwendungsbereichen innerhalb und außerhalb von Gebäuden und Fahrzeugen. Im Gegensatz zu einer punktförmigen Lichtquelle, wie einer Stehlampe oder Deckenlampe, lässt sich durch eine beleuchtete Scheibenanordnung ein sehr gleichmäßiges, flächiges Licht erzeugen. In Abhängigkeit von der verwendeten Leuchtquelle und der Ansteuerelektronik lassen sich auch verschiedene Lichteffekte realisieren. Bei der Verwendung von farbigen LEDs lassen sich insbesondere verschiedene Farbeffekte kombinieren. So lassen sich bewegende Lichteffekte durch die gezielte Ansteuerung und Löschung einzelner LEDs erzeugen. Für den Betrachter scheint sich dabei das Licht in Farbwellen auszubreiten. Überlagern sich dabei mehrere Farbwellen, so ergeben sich weitere Effekte wie eine Farbmarmorierung, der sogenannte Moiré-Effekt. Diese Licht- und Farbeffekte lassen sich auch für Werbeflächen oder zur Erzeugung künstlerischer und architektonischer Effekte nutzen.

Eine weiteres Beispiel sind Isolierverglasungen mit elektrochromer Beschichtung. Die elektrochrome Beschichtung ermöglicht durch Anlegen einer elektrischen Spannung, die Transmission einer Scheibe sofort zu ändern. Damit lässt sich die einfallende Lichtmenge in einem Gebäude sehr schnell und flexibel verändern. Die Elektroden können als Kathode, wie beispielweise Wolframoxid WO₃, oder als Anode, wie beispielsweise Nickeloxide NiOₓH_{y}, NiOₓ, oder Iridiumoxide IrOₓ., ausgebildet sein. Die Reihenfolge ist dabei variabel. Der Elektrolyt enthält mindestens eine elektrisch isolierende Schicht, beispielsweise hydriertes Tantaloxid Ta₂O₅*nH₂O, Antimonoxid Sb₂O₃, Zirkoniumdioxid ZrO₂ und/oder Titandioxid TiO₂. Die gehemmte elektrochrome Schicht enthält beispielsweise hydriertes Wolframoxid WO₃*nH₂O, Nioboxid Nb₂O₃, Nb₂O₃*nH₂O, Zinnoxid SnO₂, SnO₂*nH₂O und/oder Bismutoxid Bi₂O₃, Bi₂O₃*nH₂O. Auch ein dreigliederiger sandwichartiger Schichtaufbau wie beispielsweise Ta₂O₅*nH₂O/WO₃*nH₂O/Ta₂O₅*nH₂O ist möglich. Beispiele für entsprechende elektrochrome Beschichtungen sind in der US 6,277,523 B1 offenbart. Die elektrochrome Beschichtung wird durch die Substratoberfläche abgeschlossen. Dabei kann es sich um die Außenscheibe oder Innenscheibe handeln. Durch Anlegen einer Spannung kann dann wie erwähnt, die Transmission der Scheibe reversibel verringert werden.

Sowohl beleuchtete Scheibenanordnungen als auch elektrochrome Verglasungen erfordern eine externe Spannungsversorgung und entsprechende Anschlüsse und Kabel. Vor allem Kabel erschweren jedoch die automatisierte und maschinelle Fertigung der Isolierverglasungen. Heraushängende Kabel können zudem bei der Herstellung, Stapelung, Lagerung oder Transport beschädigt werden. Diese Kabelbrüche erfordern dann in vielen Fällen einen Austausch der gesamten Isolierverglasung. Zudem vermindern Kabelverbindungsstücke die langfristige Gasdichtigkeit.

US 6,277,523 B1 beschreibt die Bau- und Funktionsweise einer elektrochromen Beschichtung. Dabei lässt sich die Transparenz für Licht verschiedener Wellenlängen durch Anlegen einer elektrischen Ladung steuern und regulieren.

US 6,185,883 B1 offenbart ein Fenster mit dekorativen Schmuckelementen. Der Fensterrahmen umfasst eine Dreifachisolierverglasung mit dekorativen Elementen in der mittleren Scheibe.

EP 1 346 178 B1 offenbart ein sandwichartiges Plattenelement. Die beiden Platten sind weitgehend lichtdurchlässig. Im Plattenzwischenraum oder an den Platten sind Solarzellenelemente angebracht. Eine Lichtquelle ist stirnseitig an mindestens einer Platte angeordnet und ermöglicht eine zusätzliche Beleuchtung.

DE 10 2005 061 855 A1 offenbart ein Glaselement als Teil einer Fassade mit lang nachleuchtendem Effekt. Das Langnachleuchtelement umfasst ein lang nachleuchtendes Pigment in einer Matrix.

DE 10 2005 036 869 A1 offenbart eine mehrschichtige Verbundstruktur zur Verkleidung der Innen- oder Außenseite von Gebäuden- oder Gebäudeteilen. Die Verbundstruktur umfasst mindestens eine lichtdurchlässige starre Schicht, mehrere Lichtleitfaser und ein oder mehrere Anschlüsse zum Verbinden der Lichtleitfasern mit einer Lichtquelle.

DE 10 2005 050 545 A1 offenbart ein Kontaktelement für einen zwischen zwei Glasplatten angeordneten Verbraucher, beispielsweise eine Flüssigkristallfolie. Diese ist mit einer in den Plattenzwischenraum ragenden Kontaktfahne verbunden, welche mit einem am Plattenrand angeordneten Kunststoffgehäuse mit einem elektrisch leitenden Mittel verbunden ist.

Die internationale Patentanmeldung WO 00/58580 A1 zeigt eine Tür für eine Kühlauslage, bei der ein Abstandshalter für Einzelscheiben mit einem elektrischen Steckteil versehen ist. Der Abstandshalter verfügt über keine innere und äußere Isolation zu den Scheiben. Eine Heizschicht auf einer Außenscheibe wird seitlich des Steckteils elektrisch kontaktiert.

Die Aufgabe der Erfindung liegt darin, eine Isolierverglasung mit elektrischen Anschlüssen im Inneren bereitzustellen, welche ohne heraushängende Kabel transportiert und gelagert werden kann.

Ein Verfahren zur Herstellung der Isolierverglasung und die erfindungsgemäße Verwendung der Isolierverglasung gehen aus weiteren unabhängigen Ansprüchen hervor.

Die erfindungsgemäße Isolierverglasung mit einem elektrischen Anschlusselement umfasst eine erste Scheibe und eine zweite Scheibe. Die beiden Scheiben sind durch einen umlaufenden Spacer (Abstandshalter) zwischen der ersten Scheibe und der zweiten Scheibe getrennt. Die Hohlräume des Spacers enthalten bevorzugt ein Trockenmittel, besonders bevorzugt Kieselgel, CaCl₂, Na₂SO₄, Aktivkohle, Silikate, Bentonite, Zeolithe und/oder Gemische davon. Die Trockenmittel sind bevorzugt so angeordnet, dass ein Gas- und Feuchtigkeitsaustausch mit der Atmosphäre im Inneren der Isolierverglasung möglich ist, die Materialien aber nicht umherfliegen können und fixiert sind. Dies kann bevorzugt durch Einschließen der Trockenmittel in einen luft- und feuchtigkeitsdurchlässigen Polymerfilm oder in einem feinmaschigen Netz erfolgen. Um Energieeinsparmöglichkeiten ausschöpfen zu können, kann die Isolierverglasung mit einem Edelgas, vorzugsweise Argon oder Krypton befüllt werden, die den Wärmeübergangswert im Isolierverglasungszwischenraum reduzieren.

Die erste Scheibe und die zweite Scheibe weisen bevorzugt dieselben Abmessungen und Dicken auf. Die Scheiben weisen bevorzugt eine optische Transparenz von > 85 % auf. Die Scheibe enthält bevorzugt Glas und/oder Polymere, bevorzugt Flachglas, Floatglas, Quarzglas, Borosilikatglas, Kalk-Natron-Glas, Polymethylmethacrylat und/oder Gemische davon. In einer alternativen Ausführungsform kann die erste Scheibe oder die zweite Scheibe als Verbundglasscheibe ausgebildet sein. Die erfindungsgemäße Isolierverglasung bildet in diesem Fall eine Dreifachverglasung. Eine innere Isolierung ist zwischen dem Spacer und der äußeren Scheibe sowie der inneren Scheibe angeordnet. Eine äußere Isolierung befindet sich in einem Randraum zwischen der ersten Scheibe, der zweiten Scheibe und dem Spacer. Die innere Isolierung und/oder äußere Isolierung enthalten bevorzugt Polymere oder silanmodifizierte Polymere, besonders bevorzugt organische Polysulfide, Silikone, RTV (raumtemperturvernetzenden)-Silikonkautschuk, HTV-(hochtemperturvernetzenden) Silikonkautschuk, peroxidischvernetzten-Silikonkautschuk und/oder additionsvernetzten-Silikonkautschuk, Polyurethane, Buthylkautschuk und/oder Polyacrylate. Eine verbundene Steckverbindungsanordnung ist teilweise in dem Spacer integriert. Die Steckverbindungsanordnung umfasst eine innere Steckverbindung zwischen der ersten Scheibe und der zweiten Scheibe, eine mittlere Steckverbindung im Spacer und eine äußere Steckverbindung außerhalb der Isolierverglasung. Die mittlere Steckverbindung umfasst eine linke Verrastung, ein Mittelteil mit einem elektrisch durchgängigen Kontaktelement und eine rechte Verrastung. Das Kontaktelement bildet einen Teilbereich oder einen Auf- und/oder Einsatz des Mittelteils, welcher die elektrische (und mechanische) Verbindung zur inneren Steckverbindung sowie äußeren Steckverbindung herstellt. Die elektrische Kontaktierung mit der inneren Steckverbindung und äußeren Steckverbindung erfolgt bevorzugt über durchgängige elektrische Steckkontakte innerhalb des Kontaktelements. Die mittlere Steckverbindungsanordnung bildet einen Teil des Spacers oder ein in den Spacer integrierbares Mittelstück, bevorzugt einen nach außen und nach innen abgeschlossenen Teil des Spacers. Die linke Verrastung und rechte Verrastung ermöglichen ein Einstecken der mittleren Steckverbindungsanordnung in den Spacer und sind bevorzugt von einem Klebstoff wie Acrylatklebstoffe, Methylmethacrylatklebstoffe, Cyanacrylatklebstoffe, Polyepoxide, Silikonklebstoffe und/oder Silanvernetzende-Polymerklebstoffe sowie Gemische und/oder Copolymere davon oder einem Dichtstoff umgeben. Der Ausdruck "Verrastung" umfasst im Sinne der Erfindung auch profil- oder zahnlose mechanische Stecker, welche eine Verbindung zum oder in den Spacer ermöglichen. Die innere Steckverbindung, die mittlere Steckverbindung und/oder die äußere Steckverbindung umfassen bevorzugt Polymere und/oder Metalle. Die mittlere Steckverbindung ist so ausgeführt, dass der Scheibenzwischenraum bevorzugt gasdicht verschlossen ist. Dies kann über eine aufgetragene Metallfolie oder eine Metallbeschichtung erfolgen, so dass das eingefüllte Gas nicht so schnell wieder entweichen kann und gleichzeitig keine Feuchtigkeit eindringen kann. Diese Feuchtigkeit könnte sonst zu einem Beschlag der Scheiben oder gar zu einem Kurzschluss an den elektrischen Kontakten führen.

Das Kontaktelement weist bevorzugt 1 bis 12 elektrische Steckkontakte, besonders bevorzugt 4 bis 10 elektrische Steckkontakte auf. Kontaktelemente umfassen im Sinne der Erfindung Steckkontakte mit männlichem oder weiblichem Ausgang. Die Verbindung kann bevorzugt gelötet oder über Schneidkontakte erfolgen.

Die mittlere Steckverbindung weist bevorzugt eine Länge von 60 mm bis 200 mm, besonders bevorzugt 80 mm bis 150 mm auf.

Die mittlere Steckverbindung weist bevorzugt eine Breite von 8 mm bis 20 mm, bevorzugt von 10 mm bis 15 mm auf. Die Abmessungen können entsprechend den Dimensionen der Isolierverglasung variieren.

Die linke Verrastung und/oder rechte Verrastung sind bevorzugt von einer Klebung umgeben. Die Klebung gewährleistet einen sicheren Halt der Verrastung innerhalb des Spacers. Die Verrasterung dient auch zur Bevorratung von Abdichtmaterial, vorzugsweise ein Butylkautschuk oder ein silanmodifiziertes Polymer. Das Abdichtmaterial erlaubt eine feuchtigkeits- und gasdichte Abdichtung der Verrasterung. Das Abdichtmaterial ermöglicht zudem den Ausgleich zwischen temperaturbedingten und mechanischen Spannungen innerhalb des Spacers.

Die innere Steckverbindung, die mittlere Steckverbindung und/oder äußere Steckverbindung umfassen bevorzugt Stecker, Einbaustecker, Kupplungen oder Buchsen. Diese Steckverbindungen ermöglichen eine sichere und gleichzeitig reversibel lösbare Verbindung der einzelnen Steckverbindungen.

Das Kontaktelement umfasst bevorzugt einen Aufsatz, bevorzugt in Richtung der äußeren Steckverbindung. Der Aufsatz ermöglicht ein Umspritzen und damit weiteres Abdichten der mittleren Steckverbindung mit der äußeren Isolierung. Der Aufsatz weist bevorzugt eine Tiefe von 15 mm bis 30 mm auf. Der Aufsatz kann nach der endgültigen Montage der mittleren Steckverbindung im Spacers wieder entfernt werden. Alternativ kann ein geschlossener Aufsatz bis zur endgültigen Montage der äußeren Steckverbindung eine Verschmutzung des Kontaktelements verhindern.

Die linke Verrastung und/oder die rechte Verrastung umfassen bevorzugt Widerhaken oder Abspreizungen. Diese ermöglichen eine stabile und rutschsichere Befestigung in dem Spacer und verhindern ein Lösen der Verrastung innerhalb des Spacers.

Die Steckkontakte und/oder Kontaktelemente enthalten bevorzugt Silber, Kupfer, Zinn, Gold, Aluminium, Eisen, Titan, Wolfram, Chrom und/oder Legierungen davon und/oder ein leitfähiges organisches Polymer.

Die äußere Steckverbindung weist bevorzugt eine abgewinkelte Kabelzufuhr auf. Die abgewinkelte Kabelzufuhr ermöglicht einen platzsparenden Einbau der von der Isolierverglasung abstehenden äußeren Elektrik. Die abgewinkelte Kabelzufuhr verringert deutlich die Größe und Ausdehnung der an der Isolierverglasung montierten Kabel- und Elektrikverkleidung.

Zwischen der ersten Scheibe und der zweiten Scheibe ist bevorzugt eine LED-Leiste angeordnet. Die LEDs umfassen bevorzugt LEDs (Light Emitting Diodes) und/oder OLEDs (Organic Light Emitting Diodes). Die LED-Leiste ist mit der inneren Steckverbindung elektrisch verbunden. Die LED-Leiste enthält mindestens eine LED, eine an der LED befestigte LED-Leiterplatte (PCB, printed circuit board) und einen an der LED-Leiterplatte befestigten elektrischen Anschluss. Die LED-Leiterplatte umfasst handelsübliche Leiterplatten und/oder Platinen. Diese bestehen aus elektrisch isolierenden Materialien, auf denen elektrische Verbindungen angebracht sind. Beispiele für isolierende Materialien sind nicht leitfähige Polymere wie mit Epoxydharz getränkte Glasfaser, Teflon, Keramik und/oder Polyesterfolie. Die elektrischen Verbindungen, beispielsweise Leitungsdrähte, enthalten bevorzugt Kupfer, Eisen, Zinn, Nickel, Gold, Silber und/oder Legierungen davon. Auf den LED-Leiterplatten werden die LEDs befestigt und über die elektrischen Verbindungen kontaktiert. Der elektrische Anschluss stellt über die Anordnung aus innerer Steckverbindung, einer mittleren Steckverbindung und einer äußeren Steckverbindung die Verbindung zur Stromquelle her. Bevorzugt ist zwischen dem elektrischen Anschluss der äußeren Steckverbindung und der Stromquelle noch eine Steuervorrichtung angeordnet. Diese Steuervorrichtung ermöglicht die gezielte Beleuchtung einzelner LEDs. Durch die Anordnung verschiedenfarbiger LEDs auf der LED-Leiterplatte lassen sich farbige Lichteffekte erzeugen.

Die erste Scheibe und/oder zweite Scheibe weisen bevorzugt eine elektrochrome Beschichtung auf. Die elektrochrome Beschichtung ist mit der inneren Steckverbindung elektrisch verbunden.

Die erste Scheibe und/oder zweite Scheibe weisen bevorzugt ein Photovoltaik-Modul oder eine photovoltaische Beschichtung auf. Das Photovoltaikmodul oder die photovoltaische Beschichtung sind mit der inneren Steckverbindung elektrisch verbunden.

Die Erfindung umfasst des Weiteren ein Verfahren zur Herstellung einer Isolierverglasung mit einem elektrischen Anschlusselement. In einem ersten Schritt wird ein elektrischer Verbraucher auf einer ersten Scheibe der späteren Isolierverglasung angeordnet. Anschließend oder vorher wird eine mittlere Steckverbindung in einen umlaufenden Spacer eingesetzt. Im folgenden Schritt wird der elektrische Verbraucher über eine innere Steckverbindung mit der mittleren Steckverbindung elektrisch leitend verbunden. Im nächsten Schritt wird der Spacer mit einer ummantelnden inneren Isolierung zwischen der ersten Scheibe und einer zweiten Scheibe angeordnet und mit einer äußeren Isolierung zu einer Isolierverglasung zusammengesetzt. Vor dem Auftragen der äußeren Isolierung wird auf die mittlere Steckverbindung auf der nach außen gerichteten Seite bevorzugt eine Schutzkappe aufgesetzt. Nach dem Aushärten der äußeren Isolierung kann diese Schutzkappe entfernt werden. Abschließend wird die mittlere Steckverbindung mit einer äußeren Steckverbindung verbunden.

Die Erfindung umfasst des Weiteren die Verwendung der Isolierverglasung als beleuchtete Verglasung, elektrochrome Verglasung und/oder Photovoltaikmodul.

Im Folgenden wird die Erfindung anhand von Zeichnungen näher erläutert. Die Zeichnung ist eine rein schematische Darstellung und nicht maßstabsgetreu. Sie schränkt die Erfindung in keiner Weise ein. Die Zeichnung enthält:
Figur 1 a einen Querschnitt der Isolierverglasung mit einem elektrischen Anschlusselement,
Figur 1b eine Draufsicht auf den Spacer und die elektrischen Verbindungselemente,
Figur 2 eine Draufsicht der mittleren Steckverbindung,
Figur 3 eine vergrößerte Draufsicht der mittleren Steckverbindung,
Figur 4 eine Draufsicht der äußeren Steckverbindung und
Figur 5 ein Fliesschema des erfindungsgemäßen Verfahrens.

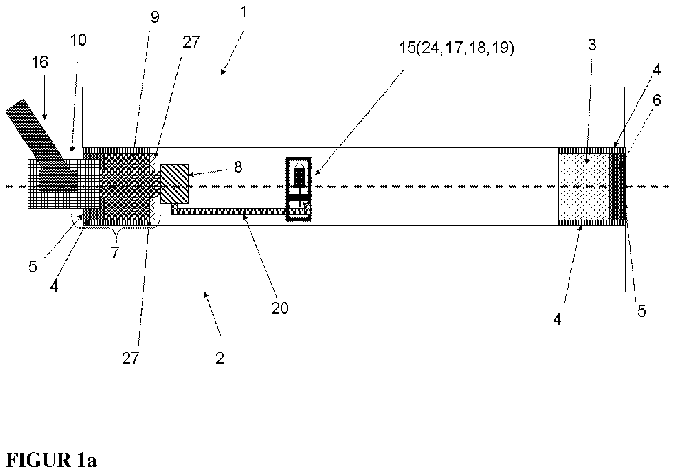

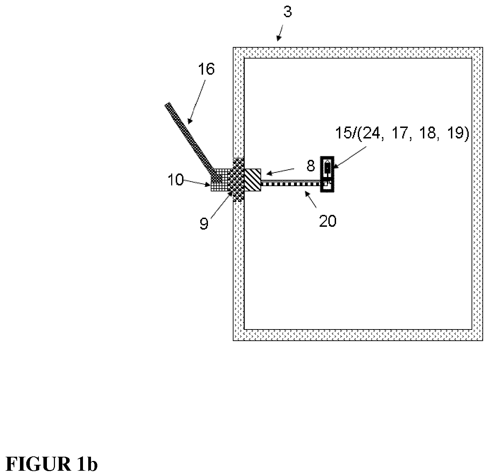

Figur 1 a zeigt einen Querschnitt der Isolierverglasung mit einer elektrischen Steckverbindungsanordnung (7). Die gestrichelte Linie gibt die gedachte mittlere horizontale Achse an. Eine erste Scheibe (1), zweite Scheibe (2), Spacer (3) und äußere Isolierung (5) bilden den Grundaufbau der Isolierverglasung. Eine in den Spacer (3) integrierte mittlere Steckverbindung (9) kann von innerhalb der Isolierverglasung mit einer inneren Steckverbindung (8) und von außerhalb der Isolierverglasung mit einer äußeren Steckverbindung (10) kontaktiert werden. Die mittlere Steckverbindung (9) weist bevorzugt auf der zum Innenraum der Isolierverglasung gerichteten Seite eine metallische Oberfläche oder Beschichtung (27) auf. Die metallische Oberfläche oder Beschichtung (27) dichtet den Innenraum der Isolierverglasung im Bereich der mittleren Steckverbindung (9) zusätzlich ab. Der Spacer (3) ist an der Kontaktfläche zur ersten Scheibe (1) und zweiten Scheibe (2) von einer inneren Isolierung (4) umgeben. Die innere Isolierung (4) kann optional bis zur oder in die äußere Isolierung (5) reichen. Die innere Isolierung (4) dichtet die Kontaktfläche des Spacers (3) zur ersten Scheibe (1) und zweiten Scheibe (2) feuchtigkeits- und gasdicht ab. Die äußere Isolierung (5) füllt den äußeren Randraum (6, gestrichelter Pfeil) zwischen der ersten Scheibe (1), Spacer (3) und zweiten Scheibe (2) komplett aus. Die innere Steckverbindung (8) ermöglicht über ein Kabel (20) die elektrische Kontaktierung eines elektrischen Verbrauchers (15), beispielsweise eine LED-Leiste (24), eine elektrochrome Beschichtung (17), ein Photovoltaik Modul (18) oder eine photovoltaische Beschichtung (19). Über die Anordnung aus abgewinkelter Kabelzufuhr (16), äußerer Steckverbindung (10), und mittlerer Steckverbindung (9) wird die innere Steckverbindung (8) mit Strom versorgt. Die abgewinkelte Kabelzufuhr (16) verringert deutlich die Größe und Ausdehnung der an der Isolierverglasung montierten nichtgezeigten Kabel- und Elektrikverkleidung. Bevorzugt ist zwischen der äußerer Steckverbindung (10) sowie der Anordnung aus abgewinkelter Kabelzufuhr (16) und der Stromquelle noch eine nicht gezeigte Steuervorrichtung angeordnet. Diese Steuervorrichtung ermöglicht die gezielte Beleuchtung einzelner LEDs. Durch die Anordnung verschiedenfarbiger LEDs auf der LED-Leiterplatte lassen sich farbige Lichteffekte erzeugen.

Figur 1b zeigt eine Draufsicht auf den Spacer (3) und die elektrischen Verbindungselemente äußere Steckverbindung (10), mittlere Steckverbindung (9) und innere Steckverbindung (8) entlang der gedachten mittleren horizontalen Achse (gestrichelte Linie) in Figur 1. Der Spacer (3) ist in Form eines Rahmens sandwitchartig zwischen der nicht gezeigten ersten Scheibe (1) und zweiten Scheibe (2) sowie der inneren Isolierung (4) und äußeren Isolierung (5) angeordnet. Über die Anordnung aus mittlerer Steckverbindung (9), äußerer Steckverbindung (10) und abgewinkelter Kabelzufuhr (16) wird die innere Steckverbindung (8) mit Strom versorgt. Ein Kabel (20) versorgt den elektrischen Verbraucher (15) und damit beispielsweise alternativ eine LED-Leiste (24), eine elektrochrome Beschichtung (17), ein Photovoltaik Modul (18) oder eine photovoltaische Beschichtung (19) mit elektrischer Spannung.

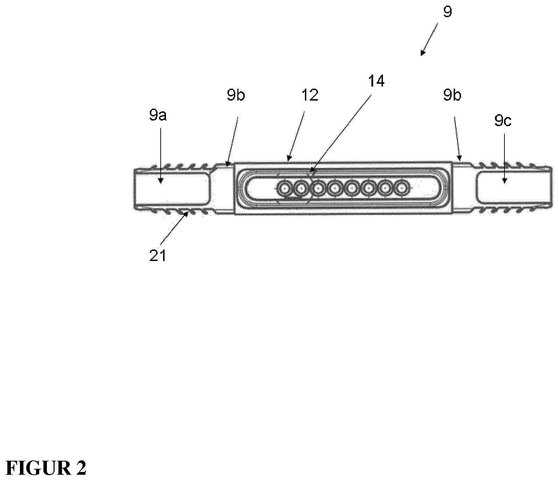

Figur 2 zeigt eine Draufsicht der mittleren Steckverbindung (9). Die mittlere Steckverbindung (9) umfasst eine linke Verrastung (9a), einen Mittelteil (9b) mit einem elektrisch durchgängigen Kontaktelement (12) und eine rechte Verrastung (9c). Die rechte Verrastung (9c) und linke Verrastung (9a) können gleich oder unterschiedlich ausgebildet sein. Die linke Verrastung (9a), das Mittelteil (9b) und die rechte Verrastung (9c) bilden bevorzugt ein Bauteil aus einem Metall oder Polymer. Die mittlere Steckverbindung (9) bildet einen Teil des Spacers (3) oder ein in den Spacer (3) integrierbares Mittelstück, bevorzugt einen nach außen und nach innen gas- und feuchtigkeitsdicht abgeschlossenen Teil des Spacers (3). Die linke Verrastung (9a) und rechte Verrastung (9c) ermöglichen ein Einstecken der mittleren Steckverbindung (9) in den Spacer (3) und sind bevorzugt von einem nicht gezeigten Klebstoff oder einer Dichtstoff umgeben. Die elektrische Kontaktierung erfolgt über Steckkontakte (14) innerhalb des Kontaktelements (12). Das Kontaktelement (12) kann alternativ auch aus mehreren verbundenen elektrischen Kontakten innerhalb der mittleren Steckverbindung (9) bestehen, welche insgesamt eine durchgehende elektrische Verbindung von innerer Steckverbindung (8) zur äußeren Steckverbindung (10) ermöglichen.

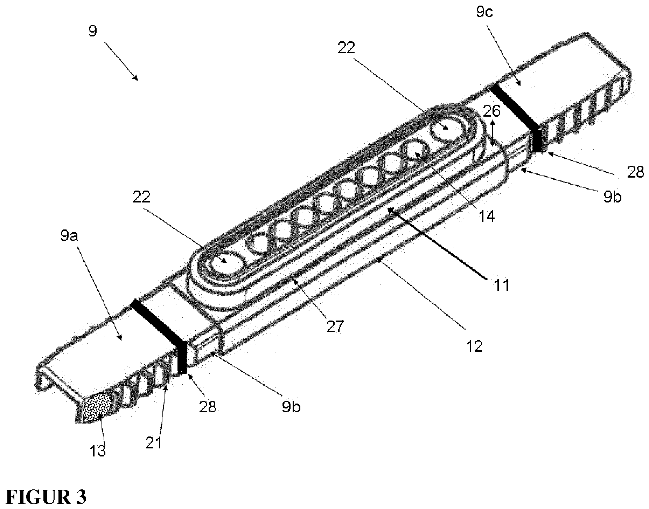

Figur 3 zeigt eine vergrößerte Draufsicht der mittleren Steckverbindung (9). Der Grundaufbau aus einer linken Verrastung (9a), einem Mittelteil (9b) mit einem elektrisch durchgängigen Kontaktelement (12) und einer rechte Verrastung (9c) entspricht dem in Figur 2 gezeigten. Das Kontaktelement (12) umfasst bevorzugt einen Aufsatz (11), welcher durch die eingezeichnete Höhe des Aufsatzes (26) bestimmt ist. Der Aufsatz (11) ist bevorzugt in Richtung der äußeren Steckverbindung (10) (nicht gezeigt) angeordnet. Der Aufsatz (11) und/oder die mittlere Steckverbindung (9) weisen bevorzugt eine metallische Oberfläche (27) mit einer Unterbrechung zu den elektrisch genutzten Steckkontakten (14) auf. Diese metallische Oberfläche vermindert den Verlust von Gas aus dem Zwischenraum zwischen der ersten Scheibe (1) und der zweiten Scheibe (2) und verhindert gleichzeitig das Eindringen von Feuchtigkeit. Schraubverbindungen (22) dienen zum Fixieren der in Figur 1 gezeigten Steckverbindungsanordnung (7) aus der inneren Steckverbindung (8), der mittleren Steckverbindung (9) und der äußeren Steckverbindung (10). Ein Dichtmaterial (28), bevorzugt ein Butylkautschuk oder ein silanmodifiziertes Polymer, ist auf der Steckverbindung (9) im Übergang zwischen der linken Verrastung (9a) und/oder rechten Verrastung (9c) und dem Mittelteil (9b) aufgetragen. Eine Klebung (13) und Abspreizungen/ Widerhacken (21) auf der linken Verrastung (9a) und rechten Verrastung (9c) sorgen für einen sicheren Halt der mittleren Steckverbindung (9) innerhalb des Spacers (3). Die Klebung (13) ist bevorzugt (nicht gezeigt) im gesamten Bereich der linken Verrastung (9a) und rechten Verrastung (9c) aufgebracht.

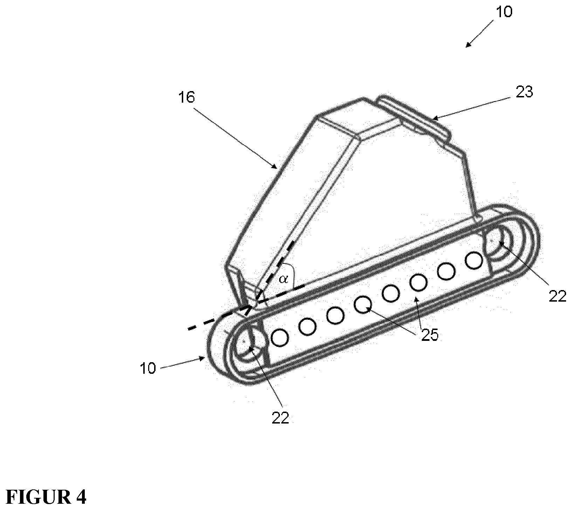

Figur 4 zeigt eine Draufsicht der äußeren Steckverbindung (10). Die elektrische Kontaktierung erfolgt über Steckkontakte (25). Die Befestigung erfolgt bevorzugt über die Schraubverbindungen (22). Die äußere Steckverbindung (10) weist bevorzugt eine abgewinkelte Kabelzuführung (16) auf. Der Winkel α, dargestellt durch die gestrichelten Linien innerhalb der abgeknickten Kabelzufuhr (16), beträgt bevorzugt 10° bis 70°, besonders bevorzugt 30° bis 60°. Die abgewinkelte Kabelzufuhr (16) mit Kabelverbindung (23) ermöglicht eine platzsparende Montage der äußeren Steckverbindung (10) und damit der gesamten erfindungsgemäßen Isolierverglasung.

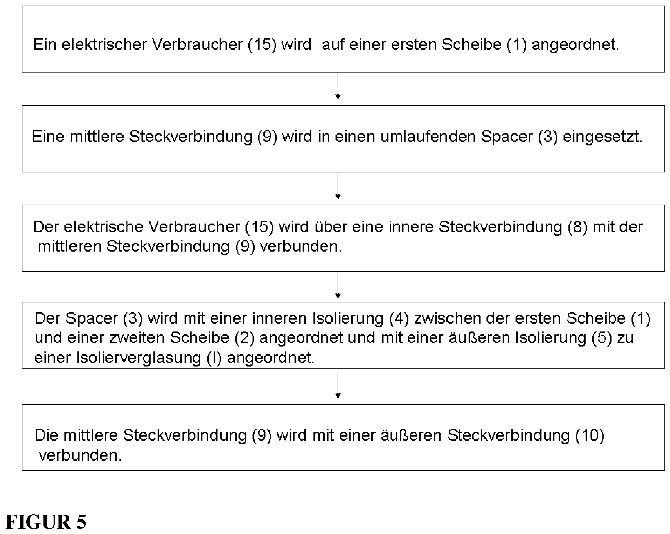

Figur 5 zeigt ein Fliesschema des erfindungsgemäßen Verfahrens. In einem ersten Schritt wird ein elektrischer Verbraucher (15), beispielsweise eine LED-Leiste (24), auf einer ersten Scheibe (1) der späteren Isolierverglasung angeordnet. Anschließend oder vorher wird eine mittlere Steckverbindung (9) in einen umlaufenden Spacer (3) eingesetzt. Im folgenden Schritt wird der elektrische Verbraucher (15) über eine innere Steckverbindung (8) mit der mittleren Steckverbindung (9) elektrisch leitend verbunden. Im nächsten Schritt wird der Spacer (3) mit einer ummantelnden inneren Isolierung (4) zwischen der ersten Scheibe (1) und einer zweiten Scheibe (2) angeordnet und mit einer äußeren Isolierung (5) zu einer Isolierverglasung zusammengesetzt. Vor dem Auftragen der äußeren Isolierung (5), beispielsweise organisches Polysulfid, wird auf der mittleren Steckverbindung (9) auf der nach außen gerichteten Seite, bevorzugt auf dem Aufsatz (11) eine Schutzkappe aufgesetzt. Nach dem Aushärten der äußeren Isolierung (5) kann die Schutzkappe entfernt werden. Die Schutzkappe verhindert ein Verkleben oder Verstopfen der Steckkontakte (14) in der mittleren Steckverbindung (9) mit Teilen der äußeren Isolierung (5). Abschließend wird die mittlere Steckverbindung (9) mit einer äußeren Steckverbindung (10) verbunden.

### Bezugszeichenliste

- (1): erste Scheibe
- (2): zweite Scheibe
- (3): Spacer
- (4): innere Isolierung
- (5): äußere Isolierung
- (6): Randraum
- (7): Steckverbindungsanordnung (8, 9, 10)
- (8): innere Steckverbindung
- (9): mittlere Steckverbindung
- (9a): linke Verrastung
- (9b): Mittelteil
- (9c): rechte Verrastung
- (10): äußere Steckverbindung
- (11): Aufsatz
- (12): Kontaktelement
- (13): Klebung
- (14): Steckkontakt
- (15): elektrischer Verbraucher
- (16): abgewinkelte Kabelzufuhr/Außenkabel
- (17): elektrochrome Beschichtung
- (18): Photovoltaik Modul
- (19): photovoltaische Beschichtung
- (20): Kabel
- (21): Abspreizungen/Widerhaken
- (22): Schraubverbindung
- (23): Kabelverbindung
- (24): LED-Leiste
- (25): Steckkontakt (äußere Steckverbindung)
- (26): Höhe des Aufsatzes
- (27): metallische Oberfläche/Metallfolie/Metallbeschichtung
- (28): Dichtmaterial

## Patentansprüche

1. Isolierverglasung mit einem elektrischen Anschlusselement, umfassend:
a. eine erste Scheibe (1), eine zweite Scheibe (2),
b. einen umlaufenden Abstandshalter (3) zwischen der ersten Scheibe (1) und der zweiten Scheibe (2),
c. eine innere Isolierung (4) zwischen dem Abstandshalter (3) und der ersten Scheibe (1) und zwischen dem Abstandshalter (3) und der zweiten Scheibe (2), wobei der Abstandshalter (3) an der Kontaktfläche zur ersten Scheibe (1) und zweiten Scheibe (2) von der inneren Isolierung (4) umgeben ist,
d. eine äußeren Isolierung (5) in einem äußeren Randraum (6) zwischen der ersten Scheibe (1), dem Abstandshalter (3) und der zweiten Scheibe (2), wobei die äußere Isolierung (5) den Randraum (6) komplett ausfüllt,
e. eine verbundene Steckverbindungsanordnung (7), wobei die Steckverbindungsanordnung (7) eine innere Steckverbindung (8) zwischen der ersten Scheibe (1) und der zweiten Scheibe (2), eine mittlere Steckverbindung (9) in dem Abstandshalter (3) und eine äußere Steckverbindung (10) umfasst, wobei
die mittlere Steckverbindung (9) eine linke Verrastung (9a), ein Mittelteil (9b) mit einem elektrisch durchgängigen Kontaktelement (12) und eine rechte Verrastung (9c) umfasst und das Kontaktelement (12) eine elektrische Verbindung zur inneren Steckverbindung (8) sowie äußeren Steckverbindung (10) herstellt und zwischen der ersten Scheibe (1) und der zweiten Scheibe (2) eine LED-Leiste (24) angeordnet ist und die LED-Leiste (24) mit der inneren Steckverbindung (8) elektrisch verbunden ist.

2. Isolierverglasung nach Anspruch 1, wobei das Kontaktelement (12) 1 bis 12 Steckkontakte (14), bevorzugt 4 bis 10 Steckkontakte aufweist.

3. Isolierverglasung nach Anspruch 1 oder 2, wobei die mittlere Steckverbindung (9) eine Länge von 60 mm bis 200 mm, bevorzugt 80 mm bis 150 mm aufweist.

4. Isolierverglasung nach einem der Ansprüche 1 bis 3, wobei die mittlere Steckverbindung (9) eine Breite von 8 mm bis 20 mm, bevorzugt von 10 mm bis 15 mm aufweist.

5. Isolierverglasung nach einem der Ansprüche 1 bis 4, wobei die linke Verrastung (9a) und/oder rechte Verrastung (9c) von einer Klebung (13) umgeben sind.

6. Isolierverglasung nach einem der Ansprüche 1 bis 5, wobei die linke Verrastung (9a), und/oder die rechte Verrastung (9c) Widerhaken oder Abspreizungen (21) umfassen.

7. Isolierverglasung nach einem der Ansprüche 1 bis 6, wobei die innere Steckverbindung (8), die mittlere Steckverbindung (9) und/oder äußere Steckverbindung (10) Stecker, Einbaustecker, Kupplungen oder Buchsen umfassen.

8. Isolierverglasung nach einem der Ansprüche 1 bis 7, wobei das Kontaktelement (12) einen Aufsatz (11), bevorzugt in Richtung der äußeren Steckverbindung (10) umfasst.

9. Isolierverglasung nach Anspruch 8, wobei der Aufsatz (11) eine Tiefe von 15 mm bis 30 mm aufweist.

10. Isolierverglasung nach einem der Ansprüche 1 bis 9, wobei die äußere Steckverbindung (10) eine abgewinkelte Kabelzufuhr (16) aufweist.

11. Isolierverglasung nach einem der Ansprüche 1 bis 10, wobei die erste Scheibe (1) und/oder zweite Scheibe (2) eine elektrochrome Beschichtung (17) aufweisen und die elektrochrome Beschichtung (17) mit der inneren Steckverbindung (8) elektrisch verbunden ist.

12. Isolierverglasung nach einem der Ansprüche 1 bis 11, wobei die erste Scheibe (1) und/oder zweiten Scheibe (2) ein Photovoltaik-Modul (18) oder eine photovoltaische Beschichtung (19) aufweisen und das Photovoltaikmodul (18) oder die photovoltaische Beschichtung (19) mit der inneren Steckverbindung (8) elektrisch verbunden sind.

13. Verfahren zur Herstellung einer Isolierverglasung mit einem elektrischen Anschlusselement nach einem der Ansprüche 1 bis 12, wobei
f. ein elektrischer Verbraucher (15) auf einer ersten Scheibe (1) angeordnet wird,
g. eine mittlere Steckverbindung (9) in einen umlaufenden Abstandshalter (3) eingesetzt wird,
h. der elektrische Verbraucher (15) über eine innere Steckverbindung (8) mit der mittleren Steckverbindung (9) verbunden wird,
i. der Abstandshalter (3) mit einer inneren Isolierung (4) zwischen der ersten Scheibe (1) und einer zweiten Scheibe (2) angeordnet und mit einer äußeren Isolierung (5) zu einer Isolierverglasung (I) angeordnet wird und
j. die mittlere Steckverbindung (9) mit einer äußeren Steckverbindung (10) verbunden wird.

14. Verwendung der Isolierverglasung nach einem der Ansprüche 1 bis 12 als beleuchtete Verglasung, elektrochrome Verglasung und/oder Photovoltaikmodul.

## Claims

1. Insulating glazing with an electrical connection element, comprising:
a. a first pane (1), a second pane (2),
b. a peripheral spacer (3) between the first pane (1) and the second pane (2),
c. an inner insulation (4) between the spacer (3) and the first pane (1) and between the spacer (3) and the second pane (2), wherein the spacer (3) is surrounded on the contact surface with the first pane (1) and the second pane (2) by an inner insulation (4),
d. an outer insulation (5) in an outer edge space (6) between the first pane (1), the spacer (3), and the second pane (2), wherein the outer insulation (5) completely fills the edge space (6),
e. a connected plug connection arrangement (7), wherein the plug connection arrangement (7) comprises an inner plug connection (8) between the first pane (1) and the second pane (2), a central plug connection (9) in the spacer (3), and an outer plug connection (10), wherein
the central plug connection (9) comprises a left-hand latching means (9a), a central part (9b) with an electrically continuous contact element (12), and a right-hand latching means (9c), and the contact element (12) produces an electrical connection to the inner plug connection (8) as well as an outer plug connection (10), and an LED strip (24) is arranged between the first pane (1) and the second pane (2), and the LED strip (24) is electrically connected to the inner plug connection (8).

2. Insulating glazing according to claim 1, wherein the contact element (12) has 1 to 12 plug contacts (14), preferably 4 to 10 plug contacts.

3. Insulating glazing according to claim 1 or 2, wherein the central plug connection (9) has a length of 60 mm to 200 mm, preferably 80 mm to 150 mm.

4. Insulating glazing according to one of claims 1 through 3, wherein the central plug connection (9) has a width of 8 mm to 20 mm, preferably of 10 mm to 15 mm.

5. Insulating glazing according to one of claims 1 through 4, wherein the left-hand latching means (9a) and/or the right-hand latching means (9c) are surrounded by an adhesive bond (13).

6. Insulating glazing according to one of claims 1 through 5, wherein the left-hand latching means (9a) and/or the right-hand latching means (9c) comprise barbed hooks or splayed arms (21).

7. Insulating glazing according to one of claims 1 through 6, wherein the inner plug connection (8), the central plug connection (9), and/or outer plug connection (10) comprise plugs, jacks, couplings, or sockets.

8. Insulating glazing according to one of claims 1 through 7, wherein the contact element (12) comprises a projection (11), preferably in the direction of the outer plug connection (10).

9. Insulating glazing according to claim 8, wherein the projection (11) has a depth of 15 mm to 30 mm.

10. Insulating glazing according to one of claims 1 through 9, wherein the outer plug connection (10) has an angled cable feed (16).

11. Insulating glazing according to one of claims 1 through 10, wherein the first pane (1) and/or second pane (2) has/have an electrochromic coating (17), and the electrochromic coating (17) is electrically connected to the inner plug connection (8).

12. Insulating glazing according to one of claims 1 through 11, wherein the first pane (1) and/or second pane (2) has/have a photovoltaic module (18) or a photovoltaic coating (19), and the photovoltaic module (18) or the photovoltaic coating (19) is/are electrically connected to the inner plug connection (8).

13. Method for producing an insulating glazing with an electrical connection element according to one of claims 1 through 12, wherein
f. an electrical load (15) is arranged on a first pane (1),
g. a central plug connection (9) is set in a peripheral spacer (3),
h. the electrical load (15) is connected via an inner plug connection (8) to the central connection (9),
i. the spacer (3) is arranged with an inner insulation (4) between the first pane (1) and a second pane (2) and is arranged with an outer insulation (5) to form an insulating glazing (I), and
j. the central plug connection (9) is connected to an outer plug connection (10).

14. Use of the insulating glazing according to one of claims 1 through 12 as illuminated glazing, electrochromic glazing, and/or a photovoltaic module.

## Revendications

1. Vitrage d'isolation avec un élément de connexion électrique comprenant :
a. une première vitre (1), une deuxième vitre (2),
b. un moyen d'espacement annulaire (3) entre la première vitre (1) et la deuxième vitre (2),
c. une isolation interne (4) entre le moyen d'espacement (3) et la première vitre (1) et entre le moyen d'espacement (3) et la deuxième vitre (2), où le moyen d'espacement (3) est entouré sur la surface de contact de la première vitre (1) et la deuxième vitre (2) par l'isolation interne (4),
d. une isolation externe (5) dans un espace extérieur en bordure (6) entre la première vitre (1), le moyen d'espacement (3) et la deuxième vitre (2), où l'isolation externe (5) remplit l'espace en bordure (6) entièrement,
e. un dispositif de connexion connecté (7), où le dispositif de connexion (7) comprend un connecteur interne (8) entre la première vitre (1) et la deuxième vitre (2), un connecteur intermédiaire (9) dans le dispositif d'espacement (3) et un connecteur externe (10), où le connecteur intermédiaire (9) comprend un enclenchement de gauche (9a), une partie centrale (9 b) avec un élément de contact électrique continu (12) et un enclenchement de droite (9c) et l'élément de contact (12) crée une connexion électrique au connecteur interne (8) ainsi qu'au connecteur externe (10) et une barre de LED (24) est disposée entre la première vitre (1) et la deuxième vitre (2) et la barre de LED (24) est reliée électriquement avec le connecteur interne (8).

2. Vitrage d'isolation selon la revendication 1, où l'élément de contact (12) présente de 1 à 12 contacts enfichables (14) de préférence de 4 à 10 contacts enfichables.

3. Vitrage d'isolation selon la revendication 1 ou 2, où le connecteur intermédiaire (9) présente une longueur de 60 mm à 200 mm, de préférence de 80 mm à 150 mm

4. Vitrage d'isolation selon l'une des revendications 1 à 3, où le connecteur intermédiaire (9) préfère une largeur de 8 mm à 20 mm, de préférence 10 mm à 15 mm.

5. Vitrage d'isolation selon l'une des revendications 1 à 4, où l'enclenchement de gauche (9a) et/ou l'enclenchement de droite (9c) sont entourés d'un collage (13).

6. Vitrage d'isolation selon l'une des revendications 1 à 5, où l'enclenchement de gauche (9a), et/ou l'enclenchement de droite (9c) comprennent des ancrages ou des écartements (21).

7. Vitrage d'isolation selon l'une des revendications 1 à 6, où le connecteur interne (8), le connecteur intermédiaire (9) et/ou le connecteur externe (10) comprennent des fiches, des connecteurs encastrables, des raccords ou des prises.

8. Vitrage d'isolation selon l'une des revendications 1 à 7, où l'élément de contact (12) comprend un embout (11), de préférence dans la direction du connecteur externe (10).

9. Vitrage d'isolation selon la revendication 8, où l'embout (11) présente une profondeur de 15 à 30 mm.

10. Vitrage d'isolation après l'une des revendications 1 à 9, où le connecteur externe (10) présente un câble d'alimentation coudé (16).

11. Vitrage d'isolation selon l'une des revendications 1 à 10, avec la première vitre (1) et/ou la deuxième vitre (2) présente un revêtement électrochromique (17) et le revêtement électrochromique (17) est raccordé électriquement avec le connecteur interne (8).

12. Vitrage d'isolation selon l'une des revendications 1 à 11, où la première vitre (1) et/ou la deuxième vitre (2) présentent un module photovoltaïque (18) ou un revêtement photovoltaïque (19) et le module photovoltaïque (18) ou le revêtement photovoltaïque (19) est raccordé électriquement avec le connecteur interne (8).

13. Procédé de fabrication de vitrage d'isolation avec un connecteur électrique à l'une des revendications 1 à 12 où
f. un consommateur électrique (15) est disposé sur une première vitre (1),
g. un connecteur intermédiaire (9) est inséré dans un dispositif d'espacement circonférentiel (3),
h. le consommateur électrique (15) est raccordé au connecteur intermédiaire (9) par un connecteur interne (8),
i. le dispositif d'espacement (3) est disposé avec une isolation interne (4) entre la première vitre (1) et une deuxième vitre (2) et avec une isolation externe (5) est disposé comme vitrage d'isolation (I) et
j. le connecteur intermédiaire (9) est raccordé avec un connecteur externe (10).

14. L'utilisation du vitrage d'isolation selon l'une des revendications 1 à 12 comme verre éclairé, vitrages électrochrome et/ou module photovoltaïque.
